# FASCICULE DE BREVET EUROPEEN

(11) **EP 3 672 381 B1**
(45) Date de publication et mention de la délivrance du brevet: **08.05.2024**
(21) Numéro de dépôt: 19213491.4
(22) Date de dépôt: 04.12.2019
(51) Int. Cl.: H05K 7/14

(54) **PROCÉDÉ D'ASSEMBLAGE D'UN ÉQUIPEMENT ÉLECTRIQUE, NOTAMMENT D'UN ONDULEUR**
ZUSAMMENBAUVERFAHREN EINES ELEKTRISCHEN GERÄTS, INSBESONDERE EINES WECHSELRICHTERS
METHOD FOR ASSEMBLING ELECTRICAL EQUIPMENT, IN PARTICULAR AN INVERTER

(30) Priorité: 21.12.2018 FR 1873977
(43) Date de publication de la demande: 24.06.2020
(73) Titulaire: Valeo eAutomotive France SAS, 95800 Cergy (FR)
(72) Inventeur: LEGENDRE, Alexandre, 95280 JOUY-LE-MOUTIER (FR); POUILLY, Aurélien, 78300 POISSY (FR)
(74) Mandataire: Valeo Powertrain Systems

(56) Documents cités:
- EP-A1- 2 535 587
- EP-A1- 2 899 866
- US-A1- 2011 261 588
- US-A1- 2012 045 353
- US-A1- 2016 324 039
- US-A1- 2018 303 001
- US-B2- 10 063 121

## Description

### DOMAINE TECHNIQUE DE L'INVENTION

La présente invention se rapporte au domaine des équipements électriques, notamment haute tension. La présente invention vise plus particulièrement l'assemblage de tels équipements électriques, notamment d'onduleurs.

### ETAT DE LA TECHNIQUE

De l'art antérieur on connaît:
EP2535587 décrivant un compresseur électrique à onduleur intégré.
EP2899866 décrivant un dispositif de conversion de puissance.
US2011/261588 décrivant un compresseur électrique à onduleur intégré.
US2016/324039 décrivant un boîtier de refroidissement pour appareil électronique.
US2018/303001 décrivant un dispositif de conversion de puissance.
Aussi, selon l'état de l'art, il est connu d'assembler des équipements électriques, notamment des onduleurs pour des systèmes de motorisation de véhicules. On introduit ainsi dans un boîtier une partie active, notamment comprenant un module électronique de puissance dans le cas d'un onduleur par exemple, des barres de conduction électrique, et des cartes électroniques. On peut aussi monter dans le boîtier un dispositif de filtrage, notamment un élément capacitif, par exemple un élément capacitif de liaison, également désigné « DC-link capacitor » en anglais, et une plaque support, également désignée « bracket » en anglais, une carte électronique pouvant être montée sur la plaque support. Puis, on ferme le boîtier au moyen d'un couvercle.

Comme cela est connu, un dispositif de filtrage de type « DC-link capacitor » a notamment pour fonction la stabilisation de la tension fournie au dispositif actif. La plaque support, également désignée « bracket », assure en particulier une fonction de protection contre les perturbations électromagnétiques, autrement dit une fonction de blindage électromagnétique. La plaque support contribue ainsi à la compatibilité électromagnétique de l'équipement électrique (désignée de manière courante en français sous l'acronyme CEM). La compatibilité électromagnétique vise à s'assurer d'une part que l'équipement électrique est apte à fonctionner lui-même sans perturbations, dans son environnement électromagnétique, et d'autre part qu'il est apte également à fonctionner sans introduire de perturbations électromagnétiques susceptibles de nuire au bon fonctionnement d'équipements électriques tiers situés à proximité.

Cependant, dans des applications de véhicules automobiles électriques ou hybrides notamment, les équipements électriques peuvent être agencés ensemble dans un seul boîtier au sein d'un système électrique. On fusionne ainsi les boîtiers des deux équipements électriques, ce qui améliore l'intégration dans le véhicule. Par exemple, un tel système électrique comprend un premier équipement électrique, tel qu'un onduleur, et un deuxième équipement électrique, tel qu'un moteur électrique, logés dans un seul boîtier. Généralement, le boîtier comprend alors un logement respectif pour chaque équipement électrique. Cependant, l'encombrement d'un tel boîtier complique l'opération d'assemblage des équipements électriques, car il est plus encombrant que les boîtiers usuels des équipements électriques pris isolément.

Il existe donc un besoin pour un système électrique tel que l'assemblage des équipements électriques soit peu impacté par l'encombrement du boîtier, ainsi qu'un procédé d'assemblage correspondant.

### PRESENTATION DE L'INVENTION

L'invention est définie par les revendications indépendantes. Les modes de réalisation préférés sont définis par les revendications dépendantes.

Ainsi, les composants de l'équipement électrique sont montés sur le couvercle du boîtier de l'équipement électrique. Grâce à l'ensemble électrique selon l'invention, les composants de l'équipement électrique peuvent donc être d'abord agencés ensemble, puis montés en une seule fois dans un boîtier de l'équipement électrique. Ainsi, il n'est pas nécessaire d'adapter la ligne d'assemblage des composants électriques de l'équipement électrique à un encombrement du boîtier dudit équipement électrique. L'invention est particulièrement avantageuse lorsque le boîtier comprend deux équipements électriques, comme c'est le cas dans un système électrique décrit précédemment.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
Fig. 1A : la figure 1A représente le premier sous-ensemble d'équipement électrique, conformément à un exemple de l'invention ;
Fig. 1B : la figure 1B représente le deuxième sous-ensemble d'équipement électrique, conformément à un exemple de l'invention ;
Fig. 1C : la figure 1C représente le troisième sous-ensemble d'équipement électrique, conformément à un exemple de l'invention ;
Fig. 2A : la figure 1B illustre schématiquement l'assemblage du deuxième sous-ensemble et du troisième sous-ensemble, selon un exemple de l'invention ;
Fig. 2B : la figure 2B illustre schématiquement l'assemblage du premier sous-ensemble au deuxième sous-ensemble et au troisième sous-ensemble, selon un exemple de l'invention.
Fig. 3 : la figure 3 montre un équipement électrique assemblé conformément à un exemple de l'invention.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite principalement en vue de la réalisation d'un onduleur, notamment destiné à alimenter une machine électrique telle qu'une machine électrique tournante d'un système de motorisation d'un véhicule. Toutefois, l'invention vise également tout équipement électrique compatible de la structure en trois sous-ensembles décrite ci-après.

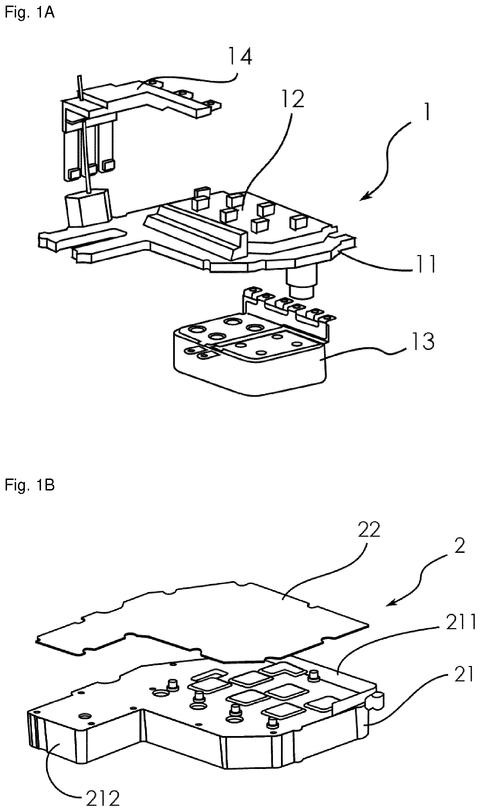

En référence aux figures 1A à 1C, la présente invention comprend dans la conception de trois sous-ensembles 1, 2, 3 de l'équipement électrique à assembler.

La figure 1A montre un premier sous-ensemble 1 comprenant un premier support 11, en l'espèce un module de refroidissement 11, auquel est fixé une partie active 12 de l'équipement électrique. Le module de refroidissement 11 peut être un module actif comprenant un réseau de circulation de liquide de refroidissement, tel qu'une boîte à eau par exemple. En particulier, la partie active 12 peut comprendre un module électronique de puissance d'un onduleur.

En particulier, un module électronique de puissance est un ensemble comprenant une pluralité de puces semi-conductrices formant un circuit électrique encapsulées dans une même enveloppe. Plus précisément, dans le présent contexte, le module électronique de puissance est par exemple un ensemble comprenant des composants par lesquels passe de l'énergie alimentant une machine électrique, par exemple un système de motorisation électrique, lesdits composants étant notamment destinés à transformer un courant continu en courants alternatifs ou vice-versa. Un tel module électronique de puissance est configuré pour permettre un passage commandé d'énergie électrique entre une batterie d'alimentation haute tension et la machine électrique.

Le premier sous-ensemble 1 peut également comprendre un dispositif de filtrage 13, pour stabiliser un signal, notamment une tension fournie à la partie active 12. Le dispositif de filtrage 13 est notamment un élément capacitif de liaison, également désigné « DC-link capacitor » en anglais. Le dispositif de filtrage 13 est par exemple vissé sur le premier support 11, notamment sur un module de refroidissement 11 auquel est fixé le dispositif actif 12.

Le premier sous-ensemble 1 peut comprendre par ailleurs une première barre de conduction électrique 14, également désigné « busbar » en anglais. En particulier, l'équipement électrique peut être un onduleur qui alimente un système de motorisation électrique polyphasé. Dans ce cas, partie active 12 est un module électronique de puissance, comme expliqué précédemment, et une telle première barre de conduction électrique 14, reliée audit module électronique de puissance, est configurée pour recevoir des connecteurs de phases du système de motorisation électrique afin d'alimenter ledit système de motorisation électrique en énergie. On désigne alors couramment ladite première barre de conduction électrique 14 sous l'expression « AC busbar » en anglais.

La figure 1B montre un deuxième sous-ensemble 2 comprenant un deuxième support 21, par exemple une plaque support 21, également désignée « bracket » en anglais. En particulier, une carte électronique 22 est fixée, notamment vissée, au deuxième support 21. Si l'équipement électrique est un onduleur, la carte électronique 22 est une carte électronique de commande de l'onduleur, et notamment du module électronique de puissance. Cette partie du deuxième sous-ensemble 2, comprenant la carte électronique 22, correspond par exemple à une zone de basse tension de l'équipement électrique.

Notamment, le deuxième support 21 assure un blindage électromagnétique, notamment pour protéger la partie active 12 de son environnement électromagnétique, et réciproquement. Le deuxième support 21, s'agissant notamment d'une plaque support 21, est par exemple une pièce de fonderie constituée d'un matériau apte à assurer une fonction de barrière vis-à-vis des perturbations électromagnétiques. Par exemple, le deuxième support 21 est en aluminium. Le deuxième support 21 comprend par exemple une plaque de base, plane, depuis laquelle peuvent s'étendre des murets 211, 212 et / ou une nervure, lesdits murets et ladite nervure étant disposés de façon à améliorer la performance de blindage électromagnétique de l'équipement électrique, une fois les sous-ensembles assemblés.

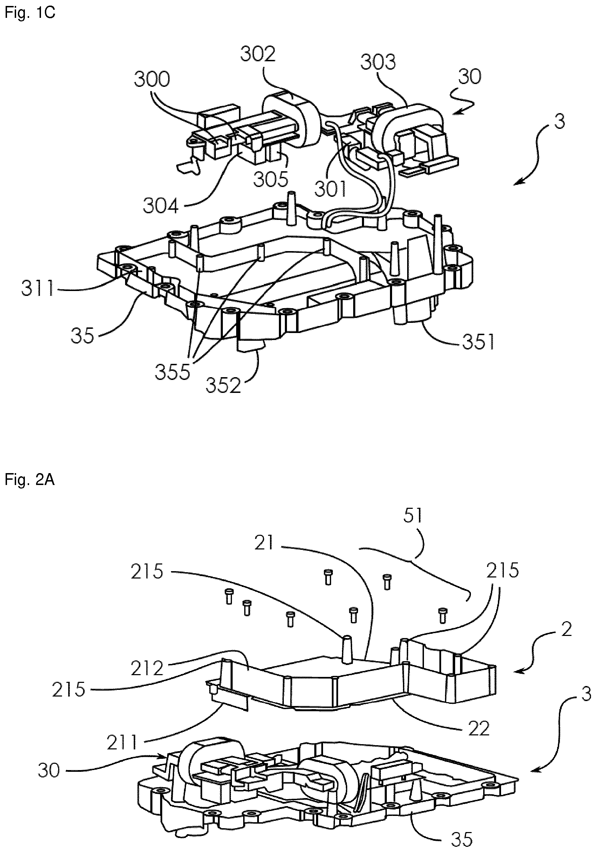

La figure 1C montre un troisième sous-ensemble 3 comprenant un troisième support 35, par exemple destiné à assurer une fonction de couvercle de l'équipement électrique. Le troisième sous-ensemble 3 comprend également une deuxième barre de conduction électrique 30 fixée, par exemple vissée, audit troisième support 35.

Par exemple, la deuxième barre de conduction électrique 30 peut comprendre des conducteurs électriques 300, également désignés « leadframes » en anglais, dans lesquels circule un signal électrique de puissance. Dans lesdits conducteurs électriques 300 circule un signal, notamment un signal de puissance telle qu'une tension délivrée par une batterie d'alimentation haute tension. La deuxième barre de conduction électrique 30 est destinée à faire partiellement le tour de la partie active 12.

La deuxième barre de conduction électrique 30 peut comprendre des éléments de filtrage dudit signal de puissance, à savoir, dans l'exemple représenté, au moins un tore de filtrage électromagnétique 302, 303 et au moins une capacité de décharge X, Y. Dans le cas où la deuxième barre de conduction électrique 30 reçoit un signal de puissance délivré par une batterie d'alimentation haute tension, les éléments de filtrage assurent le filtrage dudit signal de puissance.

La deuxième barre de conduction électrique 30 peut également comprendre un fusible 301 pour assurer une coupure de la conduction du signal de puissance en cas de dysfonctionnement.

Le troisième support 35 peut également comprendre au moins un muret 311 s'étendant orthogonalement audit troisième support 35. Ce au moins un troisième muret 311 participe alors au blindage électromagnétique de l'ensemble électrique.

Le troisième support 35, en particulier s'il assure la fonction de couvercle de l'équipement électrique, peut comprendre par ailleurs des connecteurs électriques 351, 352 configurés pour permettre la connexion de l'équipement électrique à des équipements électriques tiers.

Notamment, si l'équipement électrique est un onduleur, le troisième support 35 peut comprendre un connecteur électrique 351 pour relier l'onduleur à une batterie d'alimentation haute tension, ladite batterie haute tension fournissant une tension continue à l'onduleur, et un connecteur signal 352 pour échanger des données avec un équipement électrique tiers, tel qu'un système de gestion d'informations sur l'état d'un véhicule dans lequel se trouve ledit onduleur par exemple.

En référence à la figure 2A, selon l'invention, on assemble le deuxième sous-ensemble 2 au troisième sous-ensemble 3. Autrement dit, on fixe le deuxième support 21, par exemple la plaque support 21, notamment équipé d'une carte électronique 22, par exemple une carte électronique de contrôle d'un module électronique de puissance, au troisième support 35 équipé de la deuxième barre de conduction électrique 30, ledit troisième support 35 étant par exemple destiné à assurer une fonction de couvercle de l'équipement électrique.

Par exemple, des vis 51 sont engagées dans des fûts 215 du deuxième support 21 et vissées dans des fûts 355 correspondants prévus sur le troisième support 35.

Selon un mode de réalisation :
- une carte électronique 22 est donc vissée à un deuxième support 21, tel qu'une plaque support 21, pour former un deuxième sous-ensemble 2 ;
- une deuxième barre de conduction électrique 30, pouvant comprendre des éléments de filtrage, est vissée sur un troisième support 35 pour former un troisième sous-ensemble 3 ;
- le deuxième support 21, par exemple une plaque support, est ensuite vissé au troisième support 35.

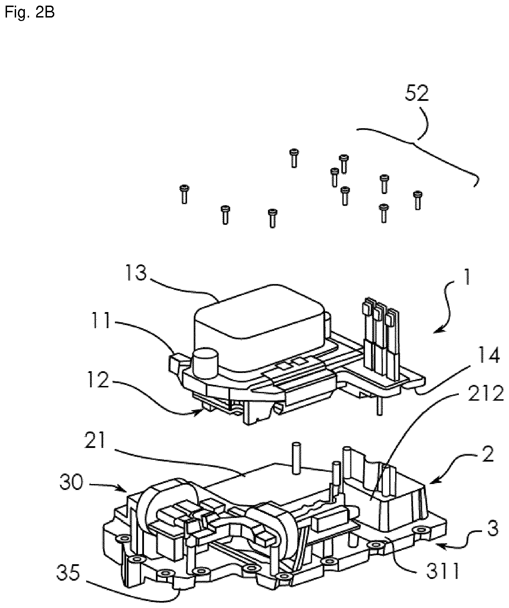

La figure 2B représente l'assemblage du premier sous-ensemble 1 à l'ensemble formé par les deuxième et troisième sous-ensembles 2, 3. Autrement dit, on fixe le premier support 11, par exemple un module de refroidissement 11, en particulier une boîte à eau, ledit premier support 11 étant notamment équipé d'une partie active 12, par exemple un module électronique de puissance, et éventuellement équipé également d'un dispositif de filtrage 13, par exemple d'un élément capacitif de liaison, et d'une première barre de conduction électrique 14, au deuxième support 21, par exemple une plaque support 21.

Notamment, des vis 52 sont engagées dans des fûts du premier support 11 et vissées dans des fûts correspondants prévus sur le deuxième support 21.

Selon un mode de réalisation :
- une partie active 12 est fixée à un premier support 11, tel qu'un module de refroidissement 11, de même que, le cas échéant, un dispositif de filtrage 13 et une première barre de conduction électrique 14, pour former un premier sous-ensemble 1 ;
- le premier support 11 est ensuite vissé au deuxième support 21 appartenant à l'ensemble précédemment formé par les deuxième et troisième sous-ensembles 2, 3.

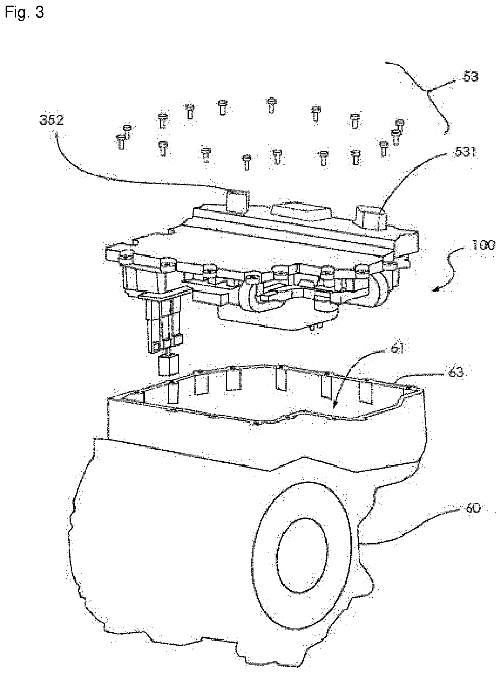

En référence à la figure 3, l'ensemble électrique 100 formé conformément aux étapes d'assemblage représentées aux figures 2A et 2B est ensuite monté dans un logement 61 d'un boîtier 60, par exemple aménagé dans une partie de châssis logeant par ailleurs, dans un autre logement dédié, un second équipement électrique. Le boîtier 60 comprend un fond, une paroi latérale et une ouverture 63 par laquelle ledit ensemble électrique 100 est introduit dans le boîtier 60, de telle sorte que le troisième support 35 ferme ledit boîtier 60. Par exemple, l'ensemble électrique 100 est vissé dans le boîtier au moyen de vis 53 engagées dans des fûts respectifs dudit ensemble électrique 100 et dudit boîtier 60.

Un avantage induit par la mise en oeuvre de l'invention réside dans le fait que la réalisation de trois sous-ensembles indépendants 1, 2, 3 permet d'augmenter la flexibilité du processus de fabrication de l'équipement électrique. Le fait de disposer de sous-ensembles indépendants 1, 2, 3 permet également de tester le bon fonctionnement de chaque sous-ensemble 1, 2, 3 de façon indépendante, et donc de réduire la quantité de rebuts éventuels.

L'équipement électrique selon l'invention est in fine représenté sur la figure 3, en vue éclatée. Ledit équipement électrique, par exemple un onduleur, présente un agencement avantageux. Ainsi, l'assemblage est réalisé de telle sorte que le dispositif de filtrage 13, en l'espèce un élément capacitif de liaison, se trouve à côté, sensiblement dans le même plan, par rapport à la deuxième barre de conduction électrique 30. La deuxième barre de conduction électrique 30 contourne ainsi le dispositif de filtrage 13, ce qui améliore la compacité de l'équipement électrique.

Autrement dit, l'empilement des premier, deuxième et troisième sous-ensemble 1, 2, 3 est réalisé de telle sorte que le troisième support 35 supporte les premier et deuxième sous-ensembles 1, 2. Ainsi, le troisième support 35 présente une plaque de base avec une première portion qui supporte la partie active 12 du premier sous-ensemble et une deuxième portion, complémentaire de la première portion, qui supporte la deuxième barre de conduction électrique 30. En particulier, la première portion de la plaque de base du troisième support 35 supporte le premier et le deuxième sous-ensembles 1, 2.

De ce fait, une fois les premier, deuxième et troisième sous-ensembles 1, 2, 3 assemblés, la carte électronique 22 se trouve intercalée entre le deuxième support 21 et le troisième support 35 ; et la partie active 12 se trouve intercalée entre le deuxième support 21 et le premier support 11. Le dispositif de filtrage 13 se trouve de l'autre côté du premier support 11 par rapport à la partie active 12. Cet agencement permet de réduire l'encombrement de l'ensemble électrique obtenu.

Selon un mode de réalisation de l'invention, pour améliorer la performance de compatibilité électromagnétique, la deuxième barre de conduction électrique 30 du troisième sous-ensemble 3 localise le passage du signal de puissance sur un côté. Cela permet de blinder aisément ce signal de puissance par rapport au reste de l'ensemble. La deuxième barre de conduction électrique peut comprendre des éléments de filtrage, déjà évoqués. Ces éléments de filtrage comprennent notamment une capacité X 304, une capacité Y 305, des tores de filtrage électromagnétique 302, 303. Un fusible de sécurité 301 peut aussi être monté sur la deuxième barre de conduction électrique 30.

Le signal de puissance induit un champ magnétique dont il faut protéger les autres parties de l'équipement électrique, en particulier la carte électronique 22. Toujours pour améliorer la performance de compatibilité électromagnétique, il est également nécessaire de protéger l'équipement électrique, en particulier la carte électronique 22, vis-à-vis de perturbations électromagnétiques provenant de l'environnement dudit équipement électrique, en particulier induit par des équipements électriques tiers destinés à fonctionner à proximité.

A cette fin, le deuxième support 21, en l'espèce une plaque support 21, comprend notamment au moins un premier muret 211, représenté sur les figures 1B, 2A et 2B, s'étendant depuis une plaque de base vers le troisième support 35. L'assemblage du deuxième sous-ensemble 2, comprenant en particulier ledit deuxième support 21, au troisième sous-ensemble 3, comprenant le troisième support 35, puis l'assemblage du premier sous-ensemble 1, comprenant en particulier la partie active 12, à l'ensemble formé par les deuxième et troisième sous-ensembles 2, 3, sont réalisés de telle sorte que ledit au moins un premier muret 211 réalise une séparation entre la deuxième barre de conduction électrique 30 et la carte électronique 22. De façon similaire, au moins un troisième muret 311 peut s'étendre orthogonalement depuis le troisième support 35 vers le deuxième support 21, pour assurer un blindage électromagnétique, également pour la carte électronique 22 notamment. Ainsi, les perturbations électromagnétiques générées par le signal circulant dans la deuxième barre de conduction électrique 30 et sur les signaux circulant dans la carte électronique 22 sont réduites.

Des murets peuvent s'étendre de part et d'autre de la plaque de base du deuxième support 21 afin de réaliser un blindage électromagnétique. Notamment, au moins un deuxième muret 212 peut s'étendre depuis la plaque de base du deuxième support 21 dans une direction opposée à celle dans laquelle s'étend le au moins un premier muret 211, de façon à réaliser un blindage électromagnétique pour la partie active 12. Avec la plaque de base du deuxième support 21, cela contribue au blindage électromagnétique entre la partie active 12 et la carte électronique 22. En outre en coopération avec le premier support 11, cela limite les perturbations électromagnétiques de la partie active 12 sur l'environnement extérieur à l'équipement électrique.

. Comme représenté sur la figure 2B, l'assemblage du premier sous-ensemble 1 sur l'ensemble formé des deuxième et troisième sous-ensembles 2, 3 est réalisé de façon à ce que la partie active 12 se trouve intercalée entre le deuxième support 21 et le premier support 11, lui-même intercalé entre la partie active 12 et le dispositif de filtrage 13.

Toujours dans ce but d'amélioration de la compatibilité électromagnétique, selon un mode de réalisation, il n'y a de préférence pas de fût traversant reliant les trois sous-ensembles 1, 2, 3. Ainsi, des fûts permettent de fixer le deuxième sous-ensemble 2 au troisième sous-ensemble 3, d'une part, et d'autres fûts permettent de fixer le premier sous-ensemble 1 sur le deuxième sous-ensemble 2. L'absence de fût traversant depuis le premier sous-ensemble 1 jusqu'au deuxième sous-ensemble 2 en traversant notamment le deuxième support 21 appartenant au troisième sous-ensemble 3 permet de minimiser la propagation de champs magnétiques, sources de perturbations électromagnétiques, depuis la partie active12 vers la barre de connexion électrique périphérique 300, et réciproquement.

## Revendications

1. Ensemble électrique destiné à être monté dans un équipement électrique, ledit ensemble comprenant :
un premier sous-ensemble (1) comprenant un premier support (11), correspondant à un module de refroidissement, une partie active (12) comprenant un module électronique de puissance d'un onduleur et une première barre de conduction électrique (14) destinée à relier ladite partie active (12) à au moins une première borne de l'équipement électrique, ladite partie active (12) et ladite première barre de conduction (14) étant montées sur ledit premier support (11),
un deuxième sous-ensemble (2) comprenant un deuxième support (21), notamment en forme de plaque (21), et une carte électronique (22), correspondant à une carte électronique de commande de l'onduleur, configurée pour commander ladite partie active (12), ladite carte électronique (22) étant montée sur ledit deuxième support (21), le deuxième support (21) comprenant des zones de fixation (215),
un troisième sous-ensemble (3) comprenant un troisième support (35) et une deuxième barre de conduction électrique (30), ladite barre de conduction électrique (30) étant montée sur ledit troisième support (35), le troisième support (35) comprenant des zones de fixation (355),
ledit deuxième sous-ensemble (2) étant fixé au troisième sous-ensemble (3) dans les zones de fixation (355) et le premier sous-ensemble (1) étant fixé au deuxième sous-ensemble (2) dans les zones de fixation (215) de façon à former un ensemble électrique (100) solidaire, ledit troisième support (35) formant un couvercle d'un boîtier d'un équipement électrique,
une première face du deuxième sous-ensemble (2) étant en vis-à-vis d'une face du premier sous-ensemble (1), et une face du troisième sous-ensemble (3) étant en vis-à-vis d'une deuxième face du deuxième sous-ensemble (2), ladite deuxième face étant opposée à la première face, de sorte que les premier, deuxième et troisième sous-ensembles (1, 2, 3) forment un empilement sur ladite face du troisième sous-ensemble (3).

2. Ensemble électrique (100) selon la revendication 1, dans lequel le premier, le deuxième et le troisième sous-ensemble (1, 2, 3) sont empilés de telle sorte que le troisième support (35) comprend une plaque de base avec une première portion qui supporte la partie active (12) du premier sous-ensemble et une deuxième portion, complémentaire de la première portion, qui supporte la deuxième barre de conduction électrique (30).

3. Equipement électrique comprenant un ensemble électrique (100) selon l'une des revendications 1 à 2, et comprenant un boîtier (60) définissant un logement (61) et comprenant une ouverture (63), l'ensemble électrique (100) comprenant les premier, deuxième et troisième sous-ensemble (1, 2, 3) étant disposé dans ledit logement (61) de telle sorte que le troisième support (35) ferme ladite ouverture (63) dudit boîtier (60), formant ainsi un couvercle de l'équipement électrique.

4. Système électrique comprenant un premier équipement électrique selon l'une des revendications 1 à 3, le boîtier du premier équipement électrique comprenant un second logement recevant un deuxième équipement électrique.

5. Système électrique selon la revendication précédente, dans lequel le premier équipement électrique forme un onduleur et le deuxième équipement électrique forme un moteur électrique destiné à être commandé par ledit onduleur.

6. Procédé d'assemblage d'un équipement électrique selon la revendication 3, ledit procédé comprenant :
la réalisation d'un premier sous-ensemble (1) comprenant un premier support (11), une partie active (12) et une première barre de connexion électrique (14) destinée à relier ladite partie active (12) à au moins une première borne de l'équipement électrique,
la réalisation d'un deuxième sous-ensemble (2) comprenant un deuxième support (21) et une carte électronique (22) configurée pour commander ladite partie active (12),
la réalisation d'un troisième sous-ensemble (3) comprenant un troisième support (35) formant un couvercle d'un boîtier de l'équipement électrique et une deuxième barre de conduction électrique (30),
une étape d'assemblage comprenant la fixation du deuxième sous-ensemble (2) au troisième sous-ensemble (3), et la fixation du premier sous-ensemble (1) au deuxième sous-ensemble (2).

7. Procédé selon la revendication 6, comprenant :
la fourniture d'un boîtier (60) définissant un logement (61) et comprenant une ouverture (63),
après l'assemblage de l'ensemble des premier, deuxième et troisième sous-ensembles (1, 2, 3), l'introduction de l'ensemble dans ledit logement (61) par ladite ouverture (63), de telle sorte que le support physique (35) réalise la fermeture de ladite ouverture (63).

8. Procédé selon l'une des revendications 6 à 7, dans lequel une première face du deuxième sous-ensemble est montée sur une face du premier sous-ensemble (1), et une face du troisième sous-ensemble (3) est monté sur une deuxième face du deuxième sous-ensemble (2), ladite deuxième face étant opposée à la première face, de sorte que les premier, deuxième et troisième sous-ensembles (1, 2, 3) forment un empilement sur ladite face du troisième sous-ensemble (3).

## Patentansprüche

1. Elektrische Einheit, die dazu bestimmt ist, in ein elektrisches Gerät montiert zu werden, wobei die Einheit Folgendes beinhaltet:
eine erste Untereinheit (1), die einen ersten Träger (11), der einem Kühlmodul entspricht, einen aktiven Teil (12), der ein elektronisches Leistungsmodul eines Wechselrichters beinhaltet, und eine erste elektrische Leiterschiene (14), die dazu bestimmt ist, den aktiven Teil (12) mit mindestens einem ersten Anschluss des elektrischen Geräts zu verbinden, beinhaltet, wobei der aktive Teil (12) und die erste Leiterschiene (14) auf dem ersten Träger (11) montiert sind,
eine zweite Untereinheit (2), die einen zweiten Träger (21), insbesondere in Form einer Platte (21), und eine elektronische Karte (22), die einer elektronischen Karte zur Steuerung des Wechselrichters entspricht und dazu konfiguriert ist, den aktiven Teil (12) zu steuern, beinhaltet, wobei die elektronische Karte (22) auf dem zweiten Träger (21) montiert ist, wobei der zweite Träger (21) Befestigungsbereiche (215) beinhaltet,
eine dritte Untereinheit (3), die einen dritten Träger (35) und eine zweite elektrische Leiterschiene (30) beinhaltet, wobei die elektrische Leiterschiene (30) auf dem dritten Träger (35) montiert ist, wobei der dritte Träger (35) Befestigungsbereiche (355) beinhaltet,
wobei die zweite Untereinheit (2) in den Befestigungsbereichen (355) an der dritten Untereinheit (3) befestigt ist und die erste Untereinheit (1) in den Befestigungsbereichen (215) an der zweiten Untereinheit (2) befestigt ist, um so eine zusammenhängende elektrische Einheit (100) zu bilden, wobei der dritte Träger (35) einen Deckel eines Gehäuses eines elektrischen Geräts bildet,
wobei sich eine erste Seite der zweiten Untereinheit (2) gegenüber einer Seite der ersten Untereinheit (1) befindet und sich eine Seite der dritten Untereinheit (3) gegenüber einer zweiten Seite der zweiten Untereinheit (2) befindet, wobei die zweite Seite der ersten Seite gegenüberliegt, sodass die erste, zweite und dritte Untereinheit (1, 2, 3) einen Stapel auf der Seite der dritten Untereinheit (3) bilden.

2. Elektrische Einheit (100) nach Anspruch 1, wobei die erste, die zweite und die dritte Untereinheit (1, 2, 3) so gestapelt sind, dass der dritte Träger (35) eine Grundplatte mit einem ersten Abschnitt, der den aktiven Teil (12) der ersten Untereinheit trägt, und einem zweiten Abschnitt, der zu dem ersten Abschnitt komplementär ist und die zweite elektrische Leiterschiene (30) trägt, beinhaltet.

3. Elektrisches Gerät, das eine elektrische Einheit (100) nach einem der Ansprüche 1 bis 2 beinhaltet und ein Gehäuse (60) beinhaltet, das eine Aufnahme (61) definiert und eine Öffnung (63) beinhaltet, wobei die elektrische Einheit (100), die die erste, zweite und dritte Untereinheit (1, 2, 3) beinhaltet, so in der Aufnahme (61) angeordnet ist, dass der dritte Träger (35) die Öffnung (63) des Gehäuses (60) verschließt und so einen Deckel des elektrischen Geräts bildet.

4. Elektrisches System, das ein erstes elektrisches Gerät nach einem der Ansprüche 1 bis 3 beinhaltet, wobei das Gehäuse des ersten elektrischen Geräts eine zweite Aufnahme beinhaltet, die ein zweites elektrisches Gerät aufnimmt.

5. Elektrisches System nach dem vorhergehenden Anspruch, wobei das erste elektrische Gerät einen Wechselrichter bildet und das zweite elektrische Gerät einen Elektromotor bildet, der dazu bestimmt ist, von dem Wechselrichter gesteuert zu werden.

6. Verfahren für den Zusammenbau eines elektrischen Geräts nach Anspruch 3, wobei das Verfahren Folgendes beinhaltet:
die Herstellung einer ersten Untereinheit (1), die einen ersten Träger (11), einen aktiven Teil (12) und eine erste elektrische Leiterschiene (14), die dazu bestimmt ist, den aktiven Teil (12) mit mindestens einem ersten Anschluss des elektrischen Geräts zu verbinden, beinhaltet,
die Herstellung einer zweiten Untereinheit (2), die einen zweiten Träger (21) und eine elektronische Karte (22), die dazu konfiguriert ist, den aktiven Teil (12) zu steuern, beinhaltet,
die Herstellung einer dritten Untereinheit (3), die einen dritten Träger (35), der einen Deckel eines Gehäuses des elektrischen Geräts bildet, und eine zweite elektrische Leiterschiene (30) beinhaltet,
wobei ein Schritt des Zusammenbauens die Befestigung der zweiten Untereinheit (2) an der dritten Untereinheit (3) und die Befestigung der ersten Untereinheit (1) an der zweiten Untereinheit (2) beinhaltet.

7. Verfahren nach Anspruch 6, das Folgendes beinhaltet:
die Bereitstellung eines Gehäuses (60), das eine Aufnahme (61) definiert und eine Öffnung (63) beinhaltet,
nach dem Zusammenbau der Einheit aus der ersten, zweiten und dritten Untereinheit (1, 2, 3), die Einführung der Einheit in die Aufnahme (61) durch die Öffnung (63), sodass der physische Träger (35) das Verschließen der Öffnung (63) bewirkt.

8. Verfahren nach einem der Ansprüche 6 bis 7, wobei eine erste Seite der zweiten Untereinheit auf einer Seite der ersten Untereinheit (1) montiert ist und eine Seite der dritten Untereinheit (3) auf einer zweiten Seite der zweiten Untereinheit (2) montiert ist, wobei die zweite Seite der ersten Seite gegenüberliegt, sodass die erste, zweite und dritte Untereinheit (1, 2, 3) einen Stapel auf der Seite der dritten Untereinheit (3) bilden.

## Claims

1. Electrical assembly intended to be mounted in an electrical equipment, said assembly comprising:
a first subassembly (1) comprising a first support (11), corresponding to a cooling module, an active part (12) comprising a power electronics module of an inverter and a first busbar (14) intended to connect said active part (12) to at least a first terminal of the electrical equipment, said active part (12) and said first busbar (14) being mounted on said first support (11),
a second subassembly (2) comprising a second support (21), notably in the form of a plate (21), and an electronic board (22) corresponding to an electronic control board of the inverter and configured to control said active part (12), said electronic board (22) being mounted on said second support (21), the second support (21) comprising fixing zones (215),
a third subassembly (3) comprising a third support (35) and a second busbar (30), said busbar (30) being mounted on said third support (35), the third support (35) comprising fixing zones (355),
said second subassembly (2) being fixed to the third subassembly (3) in the fixing zones (355) and the first subassembly (1) being fixed to the second subassembly (2) in the fixing zones (215) so as to form a one-piece electrical assembly (100), said third support (35) forming a cover for a housing of an electrical equipment,
a first face of the second subassembly (2) facing one face of the first subassembly (1), and a face of the third subassembly (3) facing a second face of the second subassembly (2), said second face being the opposite face to the first face, so that the first, second and third subassemblies (1, 2, 3) form a stack on top of said face of the third subassembly (3).

2. Electrical assembly (100) according to Claim 1, wherein the first, the second and the third subassembly (1, 2, 3) are stacked in such a way that the third support (35) comprises a baseplate having a first portion supporting the active part (12) of the first subassembly and a second portion, that complements the first portion, supporting the second busbar (30).

3. Electrical equipment comprising an electrical assembly (100) according to one of Claims 1 and 2, and comprising a housing (60) defining an accommodating space (61) and comprising an opening (63), the electrical assembly (100) comprising the first, second and third subassembly (1, 2, 3) being placed in said accommodating space (61) such that the third support (35) closes said opening (63) of said housing (60), thus forming a cover over the electrical equipment.

4. Electrical system comprising a first electrical equipment according to one of Claims 1 to 3, the housing of the first electrical equipment comprising a second accommodating space accommodating a second electrical equipment.

5. Electrical system according to the preceding claim, wherein the first electrical equipment forms an inverter and the second electrical equipment forms an electric motor intended to be controlled by said inverter.

6. Method for assembling an electrical equipment according to Claim 3, said method comprising:
creating a first subassembly (1) comprising a first support (11), an active part (12) and a first busbar (14) intended to connect said active part (12) to at least a first terminal of the electrical equipment,
creating a second subassembly (2) comprising a second support (21) and an electronic board (22) which is configured to control said active part (12),
creating a third subassembly (3) comprising a third support (35) forming a cover for a housing of the electrical equipment and a second busbar (30),
an assembly step involving fixing the second subassembly (2) to the third subassembly (3) and fixing the first subassembly (1) to the second subassembly (2).

7. Method according to Claim 6, comprising:
providing a housing (60) defining an accommodating space (61) and comprising an opening (63),
after assembling the assembly of the first, second and third subassemblies (1, 2, 3), introducing the assembly into said accommodating space (61) via said opening (63) so that the physical support (35) achieves the closing of said opening (63).

8. Method according to one of Claims 6 to 7, wherein a first face of the second subassembly is mounted on one face of the first subassembly (1), and one face of the third subassembly (3) is mounted on a second face of the second subassembly (2), said second face being the opposite face to the first face, so that the first, second and third subassemblies (1, 2, 3) form a stack on top of said face of the third subassembly (3).
